Europäisches Patentamt

European Patent Office

Office européen des brevets

(19)

(11) Numéro de publication: **0 165 121**
**A1**

## (12) DEMANDE DE BREVET EUROPEEN

(21) Numéro de dépôt: 85400909.9

(22) Date de dépôt: 10.05.85

(51) Int. Cl.⁴: **H 03 K 17/687**

(30) Priorité: **11.05.84 FR 8407278**

(43) Date de publication de la demande:
**18.12.85 Bulletin 85/51**

(84) Etats contractants désignés:
**CH DE GB IT LI SE**

(71) Demandeur: **LA TELEMECANIQUE ELECTRIQUE**
**33 bis, avenue du Maréchal Joffre**
**F-92000 Nanterre(FR)**

(72) Inventeur: **Dumortier, Bernard**
**2, bis rue Léon Loiseau**
**F-93100 Montreuil Sous Bois(FR)**

(72) Inventeur: **Gast, Jean-Noel**
**14, rue Paul Olivier**
**F-92500 Rueil Malmaison(FR)**

(74) Mandataire: **Marquer, Francis et al,**
**CABINET MOUTARD 35, avenue Victor Hugo Résidence**
**Champfleury**
**F-78180 Voisins le Bretonneux(FR)**

(54) **Dispositif de commande pour commutateur statique.**

(57) Le dispositif est associé à un pôle de commutation (10) à deux transistors MOS (MOS 1 – MOS 2) en série-opposition. Il comprend un oscillateur (22) alimenté à travers un redresseur, un démodulateur (24) relié, à travers les bornes de sortie (AB), à la grille et à la source des transistors MOS, et un organe d'isolement galvanique entre l'oscillateur et le démodulateur, constitué par un transformateur (23). L'enroulement primaire de ce dernier est alimenté en courant à haute fréquence par l'oscillateur (22), lequel est relié au circuit de tension alternative (26 – 27) par un circuit abaisseur de tension (21) associé au redresseur et est validé par un circuit interrupteur (25).

FIG. 1

- 1 -

## DISPOSITIF DE COMMANDE POUR COMMUTATEUR STATIQUE.

La présente invention concerne un dispositif de commande d'un commutateur statique pour circuit de tension alternative comportant une charge, du type comprenant au moins un transistor à effet de champ MOS ; elle concerne également la combinaison d'un tel dispositif de commande et du commutateur statique qui lui est associé.

Le dispositif de commande visé est notamment, mais non exclusivement, applicable à des pôles statiques, par exemple à des relais statiques et à des contacteurs unipolaires ou multipolaires. Le transistor MOS du dispositif considéré peut être soit un transistor de puissance, soit un transistor de pilotage de la partie puissance du commutateur.

Les dispositifs de commande connus de commutateurs statiques comprenant au moins un transistor MOS font intervenir des constituants compliqués et onéreux, notamment lorsqu'on doit assurer une tension d'isolement suffisante entre la partie commande et la partie puissance du commutateur.

Il est connu d'après la demande de brevet DE OS 30 28 986 d'utiliser pour commander un commutateur statique constitué par un MOSFET un transformateur à trois enroulements alimentés à partir d'une source de tension alternative par l'intermédiaire d'un redresseur. Deux des enroulements du transformateur sont reliés par le circuit base-collecteur d'un transistor oscillateur, tandis que le troisième enroulement est isolé des deux premiers et est relié en série avec une diode et en parallèle avec une résistance et une diode Zener au circuit grille-source du MOSFET.

Ce circuit de commande a pour inconvénient de nécessiter pour réaliser les fonctions d'isolement et d'oscillation un transformateur à trois enroulements qui est un composant coûteux.

La demande de brevet EP-89 241 montre un relais statique comportant deux MOSFET montés en série-opposition et commandés à partir d'un signal d'entrée au moyen d'un oscillateur et d'un transformateur classique à deux enroulements. L'utilisation d'un tel transformateur s'avère relativement coûteuse.

Il est également connu d'utiliser un photocoupleur pour assurer l'isolement entre la partie commande et la partie puissance du commutateur ; là encore l'organe d'isolement approprié est un composant relativement coûteux.

La présente invention a notamment pour but de parer à cet inconvénient par le recours, dans un dispositif de commande pour commutateur statique, à des constituants simples et peu onéreux assurant une tension d'isolement satisfaisante et procurant également une bonne insensibilité aux parasites et aux microcoupures. Elle vise également à faciliter l'intégration et/ou l'hybridation d'un tel dispositif seul ou en combinaison avec le commutateur statique associé, pour réaliser des pôles statiques tels que des relais statiques ou des contacteurs statiques unipolaires ou multipolaires.

L'invention concerne un dispositif de commande pour commutateur statique comprenant au moins un transistor MOS, ce dispositif présentant un oscillateur susceptible d'être relié à une source d'alimentation, un circuit démodulateur relié via des bornes de sortie du dispositif de commande respectivement à la grille et à la source du transistor MOS, tandis qu'un organe d'isolement assurant un découplage galvanique est interposé entre l'oscillateur et le circuit démodulateur, cet organe d'isolement étant constitué par un transformateur à deux enroulements, l'enroulement primaire du transformateur étant alimenté en courant à haute fréquence par l'oscillateur, caractérisé en ce que le transformateur à deux enroulements est constitué par un transformateur sans fer et en ce qu'il est prévu entre le primaire et le secondaire du transformateur sans fer un diélectrique d'épaisseur variable en fonction de la tension d'isolement souhaitée.

De préférence, la fréquence d'oscillation est supérieure à 100 kHz ; elle est par exemple de l'ordre de quelques centaines de kHz.

Il résulte de l'agencement décrit du dispositif de commande que celui-ci est bien adapté à l'alimentation en faibles courants de la grille du transistor MOS, tandis que l'isolement entre la partie commande et la partie commandée du transistor MOS est réalisé en corrélation avec l'oscillation à haute fréquence au moyen d'un transformateur sans fer particulièrement simple et peu onéreux, puisqu'il suffit d'insérer entre le primaire et le secondaire du transformateur une feuille diélectrique d'épaisseur variable en fonction de la tension d'isolement souhaitée.

De préférence, la source d'alimentation de l'oscillateur est constituée par le circuit de tension alternative, l'oscillateur étant relié audit circuit par l'intermédiaire d'un circuit redresseur et abaisseur de tension, tandis que l'oscillateur est susceptible d'être validé par un circuit interrupteur.

Le prix de revient et la souplesse d'emploi du dispositif de commande sont encore améliorés lorsque le circuit abaisseur de tension comprend une capacité déterminant la chute de tension et placée en série avec le redresseur, par exemple constitué par un redresseur simple alternance à diodes, ainsi qu'un condensateur-réservoir connecté en parallèle à une diode Zener déterminant le niveau de la tension redressée.

Le circuit redresseur-abaisseur de tension est ainsi bien adapté à l'alimentation en très faibles courants des grilles des transistors MOS ; le dimensionnement approprié de la capacité série du circuit abaisseur de tension permet en particulier d'utiliser un même circuit standard redresseur-abaisseur à grande dynamique pour des dispositifs de commande destinés à des commutateurs statiques fonctionnant par exemple de 110 à 380 volts.

L'oscillateur haute fréquence peut comporter une porte NAND de Schmitt dont la sortie est bouclée sur l'entrée via le primaire du transformateur.

Lorsqu'on utilise pour l'oscillateur un composant sous forme de circuit intégré à quadruple porte NAND, les trois autres portes peuvent servir à réaliser le circuit interrupteur du dispositif de commande en formant un montage à bascule de type RS dont une entrée assure la fonction marche et l'autre la fonction arrêt du dispositif de commande pour respectivement fermer et ouvrir le commutateur.

Les commandes de marche et d'arrêt du dispositif peuvent être réalisées soit au moyen de poussoirs, soit au moyen de phototransistors commandés par une liaison à fibres optiques.

Dans un mode de réalisation avantageux, il est prévu un circuit de décharge de la capacité inter-électrodes grille-source du transistor MOS, ce circuit comprenant de préférence un optocoupleur susceptible d'être actionné par la sortie arrêt du circuit interrupteur du dispositif de commande.

Il suffit ainsi d'un optocoupleur à faible coefficient de transfert donc peu onéreux pour permettre un fonctionnement dans l'aire de sécurité maximale du transistor MOS.

Les diverses particularités ainsi que les avantages de l'invention apparaîtront clairement à la lumière de la description ci-après :

La figure 1 représente schématiquement un dispositif de commande selon l'invention associé à un pôle de commutation à paire de transistors MOS en série opposition.

La figure 2 montre un mode de réalisation du dispositif selon l'invention.

La figure 3 montre une forme d'exécution préférée de l'oscillateur et de sa bascule de validation.

La figure 4 représente une variante de réalisation à commande par fibres optiques.

La figure 5 représente une forme d'exécution de commutateur tripolaire.

La figure 6 représente une variante de réalisation à circuit de décharge des capacités inter-électrodes des transistors MOS.

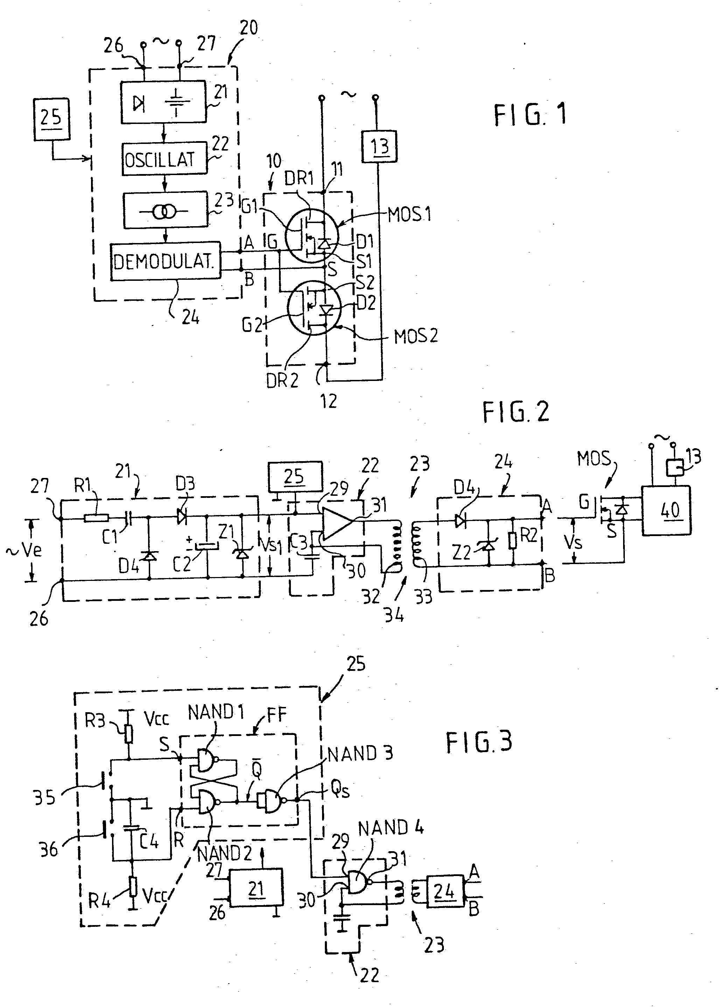

Au circuit de commutation 10 représenté sur la figure 1 est associé un dispositif de commande 20. Le circuit de commutation 10 présente des bornes 11, 12 reliées au travers d'une charge 13 à un circuit de tension alternative qui peut être constitué par exemple par un réseau de distribution basse tension 110v, 220v ou 380v, et une paire de transistors MOS 1, MOS 2, à canal N présentant respectivement une grille $G_1$, $G_2$, une source $S_1$, $S_2$, un drain $DR_1$, $DR_2$ et une diode parasite $D_1$, $D_2$. La paire de transistors MOS est montée en série-opposition, c'est-à-dire que le drain $DR_1$ est relié à la borne 11 et à la source $S_1$ via la diode $D_1$, tandis que le drain $DR_2$ est relié à la borne 12 et à la source $S_2$ via la diode $D_2$ ; les grilles $G_1$, $G_2$ des transistors MOS sont interconnectées et leur point commun G est relié à une borne de sortie A du dispositif de commande 20, tandis que les sources $S_1$, $S_2$ sont également interconnectées, leur point commun S étant relié à une borne de sortie B du dispositif 20.

Le dispositif de commande 20 comprend en série un circuit redresseur-abaisseur de tension 21, un oscillateur 22, un organe d'isolement 23 constitué selon l'invention par un transformateur sans fer et un circuit démodulateur 24 dont la sortie est reliée aux bornes A et B. Le circuit redresseur-abaisseur de tension 21 est relié à son entrée à des bornes d'entrée 26, 27 du dispositif 20 qui sont reliées au réseau alternatif alimentant la charge à commuter.

En réponse à un signal de court-circuit entre les bornes A et B généré par un circuit interrupteur ou organe de validation 25 du dispositif de commande 20, le circuit de commutation 10 se ferme pour alimenter la charge 13. Sous la forme représentée, le circuit de commutation constitue donc un pôle statique ou contacteur unipolaire. Il va de soi que par l'association ou la combinaison de trois tels circuits, on obtient un contacteur tripolaire.

Comme illustré par la figure 2, dans un mode de réalisation très simple dans lequel le transistor MOS sert au pilotage d'un commutateur statique 40 relié à la charge 13, le circuit redresseur-abaisseur de tension 21 comprend une diode $D_3$ précédée d'une résistance $R_1$ en série avec une capacité $C_1$ déterminant la chute de tension, une diode $D_4$ étant montée en parallèle aux éléments $R_1$, $C_1$. Un condensateur-réservoir $C_2$ et une diode Zener d'écrêtement $Z_1$ de tension Zener $V_{Z1}$ sont montés en parallèle à la diode $D_3$ et limitent à un niveau prédéterminé la tension redressée. Le circuit redresseur-abaisseur simple alternance ainsi réalisé produit à partir de la tension d'entrée $V_e$ qui est celle du réseau une tension de sortie $V_{S1}$ limitée à $V_{Z1}$ en fonction du choix du condensateur-réservoir $C_2$ et de la diode Zener $Z_1$. Un choix judicieux de la capacité $C_1$ permet de réaliser un circuit standard 21 à grande dynamique qui restera le même pour des réseaux à tension de 110, 220 ou 380 volts.

La tension $V_{S1}$ de sortie du circuit redresseur-abaisseur 21 alimente l'oscillateur 22, celui-ci délivrant une fréquence de l'ordre de 400 à 600 kHz et comprenant une porte NAND de Schmitt dont une entrée 29 est reliée à l'organe 21 et dans le mode de réalisation des figures 2 et 3 à l'organe de validation 25 ; une autre entrée 30 de la porte NAND est reliée à la sortie du circuit redresseur-abaisseur 21 via un condensateur $C_3$ par exemple de l'ordre de 1 nF. La sortie 31 de la porte NAND est rebouclée sur son entrée 30 par l'intermédiaire du primaire 32 du transformateur sans fer constituant l'organe d'isolement 23. Le secondaire 33 du transformateur d'isolement est relié au démodulateur 24. Du fait de l'alimentation du transformateur en haute fréquence, un simple diélectrique, par exemple sous forme de paroi en résine ou plastique ou de feuille de papier 34 interposée entre le primaire 32 et le secondaire 33 permet d'assurer l'isolement galvanique de manière très peu onéreuse entre la partie commande et la partie puissance du commutateur, la tension d'isolement étant déterminée par l'épaisseur de la paroi ou feuille diélectrique. Lorsque le diélectrique 34 est une paroi plastique, cette paroi peut avantageusement venir de moulage avec les supports des enroulements primaire 32 et secondaire 33.

Le démodulateur 24 comprend une diode $D_4$ en parallèle à laquelle on dispose une diode Zener $Z_2$ de protection et une résistance $R_2$. Le démodulateur délivre à sa sortie, c'est-à-dire entre les bornes A et B, une tension continue $V_S$ appropriée à la commande des grilles.

- 8 -     0165121

Un circuit interrupteur 25 à bascule de validation est représenté plus en détail sur la figure 3. Il comprend une bascule FF à trois portes NAND 1, NAND 2 et NAND 3 ; les portes NAND 1 et 2 sont interconnectées pour former une bascule de type RS ; les entrées R et S sont polarisées par une tension $V_{cc}$ via des résistances $R_3$, $R_4$ et sont reliées entre elles par un interrupteur "marche" 35 et un interrupteur "arrêt" 36 dont le point intermédiaire 37 est d'une part mis à la masse, d'autre part relié à une dérivation de l'interrupteur 36 présentant un condensateur $C_4$ qui impose l'une des portes NAND à zéro lors de la mise sous tension grâce à la constante de temps $R_4 C_4$.

La sortie $\bar{Q}$ de la bascule FF est reliée aux deux entrées de la porte NAND 3, ce qui permet de rendre l'ordre Arrêt prioritaire par rapport à l'ordre Marche ; la sortie $Q_s$ de la porte NAND 3 est reliée à l'oscillateur 22 et, plus précisément, quand celui-ci est réalisé au moyen d'une quatrième porte NAND 4, à l'entrée de cette porte correspondant à l'entrée 29.

Il est particulièrement intéressant de choisir pour réaliser le trigger et sa bascule de validation une quadruple porte NAND de Schmitt, par exemple un circuit intégré N° 4093 du commerce.

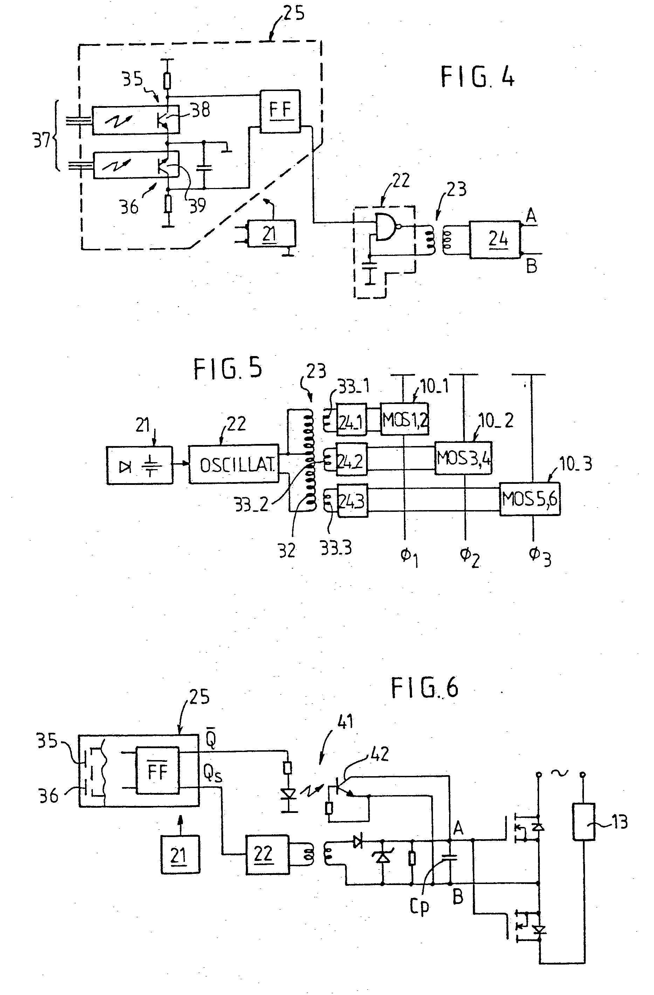

Comme l'indique la figure 4, la commande marche-arrêt peut s'effectuer au moyen d'une liaison à fibres optiques 37 et d'interrupteurs optiques, par exemple d'optotransistors 38, 39 constituant respectivement les interrupteurs de marche 35 et d'arrêt 36 ; une telle commande optique présente l'avantage d'être peu onéreuse puisqu'elle ne fonctionne qu'à une valeur de tension comprise par exemple entre 3 et 20 volts.

Pour construire un contacteur statique tripolaire, on peut aisément juxtaposer sur un même support trois paires de transistors MOS et leurs dispositifs respectifs de commande qui se prêtent particulièrement bien à une hybridation ou à une intégration.

Comme représenté sur la figure 5, on peut également former un contacteur statique tripolaire utilisant des composants discrets avec un même ensemble redresseur-abaisseur de tension 21, oscillateur 22 et un même primaire 32 pour alimenter les trois secondaires 33-1, 33-2, 33-3 de trois circuits démodulateurs 24-1, 24-2, 24-3 associés chacun à un pôle 10-1, 10-2, 10-3 ; ce dispositif permet donc de commuter trois phases $\emptyset_1$, $\emptyset_2$, $\emptyset_3$ au moyen de trois paires respectives de transistors MOS 1 et 2, MOS 3 et 4, MOS 5 et 6.

Le dispositif des figures 1 à 3 fonctionne de la manière suivante : à la mise sous tension du dispositif de commande 20, la constante de temps $R_4$ $C_4$ entraîne un retard de polarisation de R par rapport à S ; il en résulte que la sortie $\bar{Q}$ de la porte NAND 2 est mise au niveau logique 1 et la sortie $Q_s$ de la bascule au niveau logique 0.

Pour alimenter la charge 13, l'utilisateur actionne le poussoir 35 et met ainsi l'entrée S au niveau 0, de sorte que $\bar{Q}$ est amenée au niveau 0 et $Q_s$ au niveau 1. L'oscillateur est validé et alimente le primaire 32 du transformateur 33, de sorte que le démodulateur 24 délivre entre les bornes A, B une tension continue $V_s$ écrêtable par la diode Zener $Z_2$. Les grilles $G_1$, $G_2$ étant dès lors convenablement polarisées, les transistors MOS 1, MOS 2 conduisent ; le courant du réseau passe alternativement par le circuit drain-source de l'un des transistors et la diode parasite de l'autre et la charge 13 est alimentée.

En appuyant sur le poussoir 36, l'utilisateur inverse la bascule qui inhibe l'oscillateur ; les transistors MOS se bloquent et la charge 13 n'est plus alimentée.

Dans la variante de la figure 4, la commande s'effectue de manière similaire au moyen des opto-interrupteurs 35, 36.

Dans le mode de réalisation de la figure 6, il est prévu pour décharger la capacité parasite inter-électrodes $C_p$ des transistors MOS un circuit de décharge 41 ; ce circuit comprend un optocoupleur plus précisément muni d'un opto-transistor 42 optiquement couplé à la sortie "Arrêt" $\bar{Q}$ du circuit interrupteur 25 et dont le circuit émetteur-collecteur est connecté aux bornes A et B. On comprend que l'apparition du signal arrêt à la sortie $\bar{Q}$ du circuit 25 entraîne le déblocage du transistor 42 et la décharge de la capacité $C_p$ à travers ce transistor.

Il va de soi que, sans sortie du cadre de l'invention, on peut apporter des modifications aux modes de réalisation décrits. Les transistors MOS préférentiellement à canal N pourraient être à canal P moyennant une inversion de leur tension de commande. L'oscillateur 22 est d'un type quelconque délivrant une fréquence supérieure à 100 kHz. La source d'alimentation de l'oscillateur peut être constituée par un signal continu appliqué audit oscillateur, le circuit redresseur et abaisseur de tension étant alors inutile.

Revendications de brevet

1. Dispositif de commande d'un commutateur statique pour circuit de tension alternative comportant une charge, du type comprenant au moins un transistor à effet de champ MOS, le dispositif présentant un oscillateur susceptible d'être relié à une source d'alimentation, un circuit démodulateur relié via des bornes de sortie du dispositif de commande respectivement à la grille et à la source du transistor MOS, tandis qu'un organe d'isolement assurant un découplage galvanique est interposé entre l'oscillateur et le circuit démodulateur, cet organe d'isolement étant constitué par un transformateur à deux enroulements (23), l'enroulement primaire (32) du transformateur étant susceptible d'être alimenté en courant haute fréquence par l'oscillateur (22), caractérisé en ce que le transformateur à deux enroulements (23) est constitué par un transformateur sans fer et en ce qu'il est prévu entre le primaire (32) et le secondaire (33) du transformateur sans fer un diélectrique (34) d'épaisseur variable en fonction de la tension d'isolement souhaitée.

2. Dispositif de commande selon la revendication 1, caractérisé en ce que la source d'alimentation de l'oscillateur est constituée par le circuit de tension alternative, l'oscillateur étant relié audit circuit par l'intermédiaire d'un circuit redresseur et d'un abaisseur de tension (21), tandis que l'oscillateur (22) est susceptible d'être validé par un circuit interrupteur (25).

3. Dispositif de commande selon l'une des revendications 1 et 2, caractérisé en ce que la fréquence délivrée par l'oscillateur (22) est supérieure à environ 100 kHz.

4. Dispositif de commande selon l'une des revendications 2 et 3, caractérisé en ce que le circuit abaisseur de tension (21) est associé à un redresseur simple alternance à diodes $D_3$, $D_4$, et comprend une capacité $C_1$ placée en série avec le redresseur et déterminant la chute de tension, ainsi qu'un condensateur-réservoir $C_2$ connecté en parallèle à une diode Zener $Z_1$ déterminant le niveau de la tension redressée.

5. Dispositif de commande selon l'une des revendications 2 à 4,
caractérisé en ce que l'oscillateur (22) est constitué par une porte NAND de Schmitt dont la sortie (31) est bouclée sur l'une des entrées (30) par le primaire (32) du transformateur sans fer à deux enroulements (23).

6. Dispositif de commande selon l'une des revendications 2 à 5,
caractérisé en ce que le circuit interrupteur (25) comporte une bascule FF interposée entre le circuit abaisseur de tension (21) et l'oscillateur (22) pour valider celui-ci.

7. Dispositif de commande selon l'une des revendications 2 à 6,
caractérisé en ce que le circuit interrupteur (25) comprend des interrupteurs optiques (38, 39) commandés par fibres optiques (37).

8. Dispositif de commande selon l'une des revendications 1 à 7,
caractérisé en ce qu'il est prévu un circuit de décharge (41) de la capacité inter-électrodes $C_p$ du transistor MOS, ce circuit étant commandé via un optocoupleur par la sortie arrêt $\bar{Q}$ du circuit interrupteur (25).

9. Commutateur statique pour circuit de tension alternative, du type comprenant une paire de transistors MOS en série-opposition, intégré et/ou hybridé avec le dispositif de commande selon l'une des revendications 1 à 8.

10. Commutateur statique pour circuit de tension alternative, du type comprenant un circuit de commutation de puissance et un transistor MOS de pilotage du circuit de commutation, intégré et/ou hybridé avec le dispositif de commande selon l'une des revendications 1 à 8.

0165121

1 / 2

FIG. 1

FIG. 2

FIG. 3

FIG. 4

FIG. 5

FIG. 6

**0165121**
Numero de la demande

# RAPPORT DE RECHERCHE EUROPEENNE

Office européen
des brevets

EP  85 40 0909

## DOCUMENTS CONSIDERES COMME PERTINENTS

| Catégorie | Citation du document avec indication. en cas de besoin des parties pertinentes | Revendication concernee | CLASSEMENT DE LA DEMANDE (Int Cl 4) |
|---|---|---|---|
| D,A | DE-A-3 028 986  (SIEMENS) <br> * Pages 3,4; figure * | 1,2 | H 03 K  17/687 |
| A | US-A-4 438 356  (FLEISCHER) <br><br> *  Colonne  1, ligne 31 - colonne 5, ligne 40; figures 1,2 * | 1,3,5, 9 | |
| D,A | EP-A-0 089 241  (FANUC LTD.) <br> *  Page  4,  ligne  4  - page 10, ligne 16; figures 1,3 * | 1,9 | |
| A | US-A-4 302 687  (YOSHINO et al.) <br> * Colonne 4, lignes 7-12; colonne 6, lignes 19-22; figures 5,10 * | 10 | |

DOMAINES TECHNIQUES RECHERCHES (Int Cl.4)

H 03 K

Le présent rapport de recherche a été établi pour toutes les revendications

| Lieu de la recherche <br> LA HAYE | Date d'achèvement de la recherche <br> 19-08-1985 | Examinateur <br> CANTARELLI R.J.H. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& · membre de la même famille, document correspondant

OEB Form 1503 03 82